# EUROPEAN PATENT APPLICATION

(11) **EP 1 919 006 A1**
(43) Date of publication of application: **07.05.2008**
(21) Application number: 06778471.0
(22) Date of filing: 28.07.2006
(51) Int. Cl.: H01L 51/00, B05D 5/12

(54) **METHOD OF OBTAINING PATTERNS IN AN ORGANIC CONDUCTOR SUBSTRATE AND ORGANIC MATERIAL THUS OBTAINED**

(30) Priority: 29.07.2005 ES 200501879
(71) Applicant: Consejo Superior de Investigaciones Cientificas, 28006 Madrid (ES); ICFO - Instituto De Ciencias Fotonicas, 08860 Castelldefels (Barcelona) (ES); Institució Catalana de Recerca i Estudis Avançats, 08010 Barcelona (ES)
(72) Inventor: VECIANA MIRÓ, Jaume, Insto. de Ciencia de Mat., 08193 Bellaterra (Barcelona) (ES); ROVIRA ANGULO, María C., Insto. De Ciencia de Mat, 08193 Bellatera (Barcelona) (ES); LAUKHINA, Elena E., Insto. de Ciencia de Mat., 08193 Bellatera (Barcelona) (ES); MAS TORRENT, Marta, Insto. de Ciencia de Mat., 08193 Bellatera (Barcelona) (ES); LAUKHIN, Vladimir, INSTITUCIÓ CATALANA DE RECERCA, E-08010 Barcelona (ES); PETROV, Dmitri V., ICFO, 08860 Castelldefels (Barcelona) (ES); CREELY, Caitriona M., ICFO, 08860 Castelldefels (Barcelona) (ES)
(74) Representative: Ungria Lopez, Javier
(86) International application number: PCT/ES2006/070118
(87) International publication number: WO 2007/014975

(57) **Abstract**

The invention relates to a chemical method that enables the direct design of a pattern on an organic substrate having semiconductor-, superconductor- or metallic- type conducting properties. The invention also relates to the organic material thus obtained, which is intended for use in electronic devices, such as resistors, capacitors, transistors, sensors or electrodes among others, or for use in other applications requiring a determined pattern of conductor or semiconductor zones and less-conducting, non-conducting or insulating zones.

## Description

### Field of the invention

The present invention relates to a chemical method that enables the direct design of a pattern on an organic substrate having semiconductor, superconductor or metallic type conducting properties.

The invention also relates to the organic material thus obtained, which is intended for use in electronic devices, such as resistors, capacitors, transistors, sensors or electrodes among others, or for use in other applications requiring a determined pattern of conductor or semiconductor zones and less-conducting, non-conducting or insulating zones.

### Background of the invention

Generally speaking, the components of electronic devices are based on inorganic semiconductors and, more specifically on silicon.

However, due to the characteristics and limitations of silicon technology, there is a large scientific effort currently dedicated to developing molecular electronics and plastic electronics. Organic electronic devices would offer properties such as flexibility, low weight, moldeability, manufacturability, low cost and bio-compatibility versus the properties offered by current silicon-based electronic devices.

Nevertheless, to be able to use organic materials in various devices such as chips, it is essential to develop techniques that enable designing, at will, a pattern, (known as patterning techniques) that must be compatible with the processing stages and that also permits designing the circuits. The existing organic materials patterning techniques can be divided in four groups:
1. Optical lithograph: This technique is based on the transfer of a geometric shape on a mask to a substrate. To achieve this purpose, the substrate is covered with a specific polymeric material and then is exposed to ultraviolet radiation through the mask. The solubility properties of the part of the polymer exposed to radiation are modified by said exposure so the polymer becomes more or less soluble in a specific organic solvent. The part of the polymer that becomes more soluble can then be eliminated by dissolving it, which leaves a pattern on the substrate. This process enables depositing an organic material over the zones that are not covered by the polymeric material. Finally, by dissolving it with another solvent, the remaining part of the polymer can be eliminated, leaving on the substrate only the organic material with the desired pattern.
   An alternative to this technique is to expose the organic compound to be used in the patterning process (*in English in the original*) directly to ultraviolet radiation. This process however may result in the chemical or physical deterioration of the film covering the organic material.
   One of the main disadvantages of these techniques is that they require organic solvents that may harm the organic materials on which they act. Also, the process has a relatively high cost per unit area and the substrate size is limited by the area that may be exposed to radiation and by the wave length of the radiation that will determine, in part, the maximum level of lateral resolution that may be attained with this technique.
2. Mask patterning: This technique is based on the evaporation of an organic material placed on top of a substrate through a mask that contains a pattern. This is a dry process because it does not require organic solvents that could modify or deteriorate the active material. The size of the mask is the limiting factor of the technique. The mask has usually a 25 -30 micras resolution, although it can be improved by angle - shadow- evaporation. Another limitation is that the organic material must be evaporated at a temperature that does not decompose it, something that is not possible on occasion unless very small work pressures are applied.
3. Printing techniques: These techniques are of great relevance in terms of preparing low cost devices that require covering of large areas and flexible substrates. The techniques that can be encompassed under this category are as follows:
   ■ *Screen printing:* it entails passing an organic material dilution through a masked surface. The resolution is limited to 75 micras structures.
   ■ *Ink-jet printing:* it simply entails substituting the printer's ink for an organic material dilution. The smallest possible structures that can still be drawn have a size of approximately 25 micras, but sizes having 200 nm channels can be attained provided methods that rupture the organic film are used (based on molecule-substrate interactions).
   ■ *Laser thermal transfer printing:* a dry process used to print large areas by transferring an organic film using ablative methods. It entails irradiating the rear part of a multilayer film with an infrared laser beam over the areas where it is intended to transfer the polymer onto a substrate. The radiation turns into heat and causes the formation or air bubbles in the areas where the organic material decomposes. These, in turn, push the organic polymer over the receptor substrate without decomposing or altering the organic polymer.
   ■ *Microcontact printing:* this is a microcontact driven printing process in which materials from a stamp are transferred to a substrate driven by the nanometric scale interactions between the substrate and the stamp. This method makes possible obtain resolutions of up to 30 nm.
   ■ *Embossing:* this process is used to print microstructures on thermoplastic materials.
   ■ *Cold Welding:* refers to the formation of a metallic bond between two metallic surfaces when pressured is applied.
   ■ *Soft Lamination of Electrodes:* the electrodes are designed independently on a substrate and then they are laminated in a second stage on a substrate.
   ■ *Hot Lift-Off:* Is a subtractive method during which a pattern stamp formed by an epoxy polymer is pressed on top of an organic film and heated. After the stamp is removed the part of the film that has been in contact with it is also removed because it is adhered to it.
4. Selective electrochemical polymerization: organic conductive polymer film can be formed by electropolymerization from solutions of the precursor monomers.

Patent EP134026 describes a method to manufacture a continuous film of compound material that has an electric conductive surface formed by charge transfer organic complexes and the core is composed of an insulator or semiconductive polymer. To obtain said film, a solid solution is prepared with a donor and/or acceptor compound having low molecular weight and a non-conductive polymer. The polymer is softened by treating it with the vapors of an organic solvent and the organic material migrates to the surface where it crystallizes forming a conductor surface. However, the continuous film obtained by this procedure does not contain a pattern and therefore there are still some aspects that need to be solved in order to obtain from these continuous conductor films organic electronic components having a pattern with a design suitable for subsequent application.

### Brief description of the invention

A first aspect of the invention is to provide a chemical method that enables the design of a pattern on an organic substrate having semiconductor, superconductor or metallic type conducting properties (from now on the "organic conductive substrate") from a heat source.

According to the first aspect of the invention a method to obtain patterns that enable a direct design of a pattern on an organic conductor substrate is provided. The second aspect of the invention provides an organic material that can be obtained from the method defined according to the first aspect of the invention. An organic material having different electrical properties on its surface that have been custom designed is provided according to the second aspect of the invention.

### Detailed description of the invention

To the effects of the present invention the term organic conductive substrate is used to refer to a salt or charge transfer complex having conductive properties and comprising a molecule B and a dopant F, where
said molecule B is an organic molecule or macromolecule that donates or accepts electrons and is capable of forming a salt or conductive complex but cannot however show conductivity without being doped first, and
said dopant F is an electron acceptor or donor compound that has oxidative or reductive properties, and is capable of forming a salt or conductive complex with the molecule or macromolecule B.

Said molecule or macromolecule B maybe is a derivative from acene, coronene, tetrathiafulvalene, tetracyanokinodimethane or a conjugated polymer such as polythiofen, polyaniline, polyvinylphenylene, etc.

Preferably, said molecule B is bis(ethylenthio)tetrathiafulvalene (BET-TTF), bis(ethylendithio)tetrathiafulvalene (BEDT-TTF) or bis(ethylendioxo) tetrathiafulvalene (BEDO-TTF).

Preferably, said dopant F is a volatile species. Advantageously, said volatile species is selected from amongst iodine, bromine or iodine bromide.

Advantageously said salt is selected from amongst α-(BEDT-TTF) ₂I₃ and β- (BET-TTF) _{2,5}I₃, where BET-TTF bis(ethylenthio)tetrathiafulvalene and BEDT-TTF is bis(ethylendithio)tetrathiafulvalene.

According to the first aspect of the invention a method is provided to obtain patterns over an organic conductive substrate that entails the following steps:
expose an organic conductive substrate to a heat source,
where said organic conductive substrate is a salt or conductive complex that comprises a molecule B and a dopant F, and where said molecule B is an organic electron donor or acceptor molecule or capable to form a salt or conductive complex and where said dopant F is an electron acceptor or donor compound, preferably volatile, capable of forming a salt or conductive complex with the molecule or macromolecule B,
in such a manner that it triggers a thermal reaction that modifies the chemical composition of said organic substrate leaving areas free of dopant F according to the following reaction:

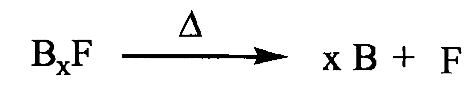

Optionally, the heat source may be applied in a localized manner over the organic conductive substrate following a pattern designed at the millimetric, micrometric or nanometric scale, or in a general manner over the entire surface by using intermediate thermal isolation masks having a specific pattern previously designed to that effect.

Optionally a mask can also be used over the organic substrate that is heated up so that the part of the mask in contact with the organic substrate is where the thermal reaction takes place.

Therefore, an expert in the matter would know as part of the general knowledge related to the art how to select the type of heat source depending on whether said exposure was to be done locally, such as for example is the case when using electromagnetic radiation, or in a general manner throughout the surface as for instance, when using a luminous or electronic heat source that is irradiated through the mask.

The most often used masks are polymeric type masks, although, also part of the general knowledge of an expert on the art entails knowing how to select the most suitable type of mask according to the type of heat source that has been selected.

The desired pattern is provided, as per the method according to the first aspect of the invention, over the conductive surface of the organic substrate using a local heat source that may be a laser radiation or a hot point, or a non-local heat source if an intermediate mask is used.

Also an object of the present invention is to carry out the procedure according to the first inventive aspect over an organic conductive substrate that comprises a base substrate of a different nature. Said base substrate may be a layer of a different composition from that of the organic conductive substrate intimately linked to it or a layer adhered by physical or chemical means to the organic conductive substrate.

Surprisingly, with the method object of the invention a pattern is obtained from a chemical reaction -defined above- in which the heat causes the elimination of dopant F, and leaving in its wake, consequently, a non-conductive surface. In this manner, for instance, dopant F is eliminated by evaporation when it is a volatile species.

The final result is, therefore, an organic material having different conductive properties on its surface as designed by a pattern that has been previously chosen according to the requirements of the final application of said material.

Also object of the present invention is an organic material that can be obtained according to the first aspect of the invention that comprises a base substrate. Said base substrate may be inorganic, such as could be silicon oxide, metallic or polymeric alumina oxide, and flexible or over a three-dimensional glass (sic). Preferably, said base substrate is a non-conductive organic polymer. More preferable yet is to select it from amongst polycarbonate, polymethylmethacrylate, polyethylene or polypropylene.

Advantageously, the method defined in the first aspect of the invention does not require using organic solvents on the organic conductive material, avoiding the stages where the material is transferred between different substrates since the pattern is obtained, according to the method object of the invention, directly over the desired surface using a point source that generates heat locally such as can be a laser beam, an atomic force microscopy point, amongst other, o another heat source used in the presence of an intermediate thermal isolating mask.

Advantageously, the inventive method only requires small amounts of conductive material, which undoubtedly makes the procedure a very economic method, useful to manufacture electronic circuit elements patterns such as resistors, condensers or transistors, amongst other and also to design organic electrodes or manufacture sensors.

Although providing a method of obtaining said organic conductive substrate is not an object of the present invention, one of the possible manners of obtaining an organic conductive substrate is explained in detail below, followed by the method used to obtain patterns over said substrate according to the inventive method.

For a greater understanding of said detailed description the term: "Organic molecule B" is understood to be an organic electron donor or acceptor molecule or macromolecule that can form a salt or conductive complex and it is preferably a derivative of tetrathiafulvalene.

The term "Polymer C" is understood to be an organic non-conductive polymer soluble in an organic solvent that is preferably a polycarbonate, polymethylmethacrylate, polyethylene or polypropylene.

The term "Solvent D" is understood as any solvent in which B and C are soluble at a given temperature that does not alter these two compounds.

The term "Solution A" is understood as the homogenous dilution of B, C and D. Solid film A' is obtained when said solution is deposited on a substrate and the solvent is left to evaporate.

The term "Film A"' is used to represent a solid solution, generally the solution formed by B and C, in which it is possible that a small portion of solvent D is left trapped.

The term "Solvent E" is used to represent a volatile organic solvent that solubilizes dopant F.

The term "Dopant F" is used to represent an electron acceptor or donor compound that may have oxidative or reductive properties capable to form a salt or conductive complex with molecule or macromolecule B. It is preferably a volatile species such as iodine, bromine or iodine bromide.

The term "Organic conductive substrate" is used to represent a salt or charge transfer complex BF formed by molecule or macromolecule B and dopant F and displays conductive properties (semiconductive, superconductive or metallic).

The following steps are required to obtain the organic conductive substrate:
1. First, a solid solution A having a mass, preferably between 0.5% and 4% of an organic molecule or macromolecule B in a non-conductive polymer is prepared in an organic solvent D. To prepare this dilution it may be necessary to heat up the mixture.
2. From dilution A a solid film A' is prepared, preferably using the drop-casting method (direct deposition of the solution over a substrate), or the spin-coating method (deposition of the solution over a rotating substrate). This stage may also require heating up the substrate to evaporate the solvent from the dilution.
3. Film A' is exposed to the vapors of an organic solvent E containing a volatile dopant F. This process induces the polymer to swell up causing a migration of molecule or macromolecule B towards the surface or surfaces treated. Also, molecule or macromolecule B reacts with dopant F creating the salt or BF complex having conductive properties.
   The film or organic conductive substrate can also be prepared using other methods such as direct evaporation of the precursor compounds B and F, which generates directly a film or organic conductive substrate from the salt or BF complex, and therefore, stages 1-3 can be modified.
   To obtain a pattern over said substrate according to the inventive method and additional Step 4 must be completed.
4. This stage entails exposing said organic conductive substrate to a heat source so a thermal reaction that modifies the chemical composition of said organic substrate takes place, leaving areas free of dopant F according to the following reaction:

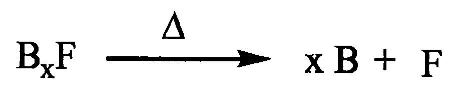

Advantageously, this last stage enables drawing the desire pattern over the conductive surface of the organic substrate by eliminating dopant F.

The result is an organic material containing a custom made design over a base substrate that will be a flexible polymer if the films are prepared according to the method described in stages 1-3 defined above.

The pattern on the conductor surface may be especially designed to prepare electric elements such as organic electrodes or sensors, or electronic components such as resistors, condensers or transistors.

The resolution of the inventive method will be determined by the diameter of the radiation beam if a luminous source is used, however, nanometric resolutions can also be attained if hot AFM points or electron lithographs are used.

### Description of the drawings

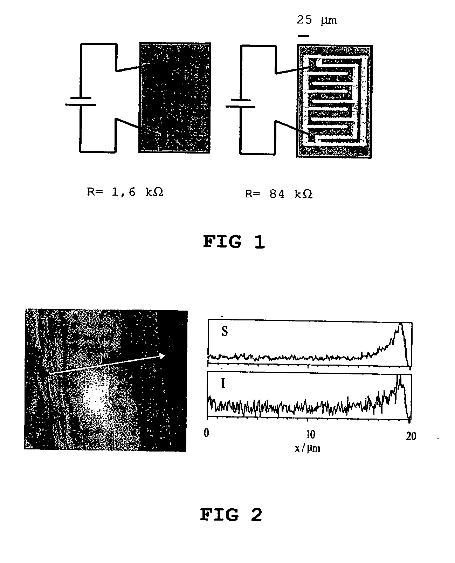

**Figure 1** shows the resistance measured on an organic conductive substrate before and after carrying out the steps of the inventive method according to the first aspect of the invention, where the average length and width of the eight conductive channels is of 75 and 8 micrometers respectively.

**Figure 2** shows the profile of the sulphur (S) and iodine (I) content analysis before carrying out the inventive method, of an organic conductive substrate that comprises a non-conductive base substrate. The figure shows that the organic substrate, in this case a salt β-(BET-TTF) _{2,5}I₃, is a conductor.

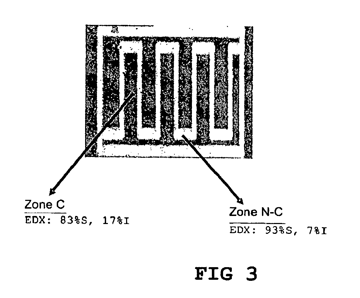

**Figure 3** shows the values obtained by energy dispersive X-ray spectroscopy (EDX) of the conductive zone C (dark area) and of the non-conductive zone N-C (clear area) formed when carrying out the steps of the inventive method.

### Examples

### Example 1. Patterning over films based on α- (BET-TTF) ₂I₃ and polycarbonate

A mixture of 0.98 g of poly-(bisphenol-A-carbonate) (PC) and 0.02 g of bis(ethylenodithio)-tetrathiafulvalene (BEDT-TTF) is prepared in 50 ml of 1,2-dichlorobenzene and then heated at 80°C until completely dissolved. The resulting solution is deposited over a glass surface at 130 °C and is left for the solvent to evaporate obtaining a film of about 20 micras thickness. The next step is to expose the surface of the film to the vapors of a saturated solution of iodine in methylene chloride, which causes the formation of a semiconductive surface layer formed by micro and nanocrystals of salt α-(BEDT-TTF) ₂I₃. These films have been characterized by X-rays, electronic microscopy and energy dispersive X-ray spectroscopy (EDX). Their electric properties have also been characterized: their conductivity at ambient temperature is of 10 S/cm.

The desired pattern is drawn directly on the conductor surface by irradiating it with a Nd:YAG laser (1064 nm). The heat caused by the radiation eliminates the halogen element and subsequently, the irradiated zone ceases to be conductive. This fact has been verified studying the current-voltage responses obtained locally with an atomic force microscope point. It has also been verified by means of EDX analysis that the relative atomic percentage of sulphur (from the tetrathiafulvalene derivative) and iodine go from 85% and 15%, respectively, in the non-irradiated zones to 98% and 2%, respectively, in the irradiated zones. This iodine loss is the reason for the loss of conductivity of the film.

### Example 2. Patterning and manufacture of electronic devices based on β- (BET-TTF) _{2.5}I₃ and polycarbonate

A dilution is formed by dissolving 0.98 g of poly-(bisphenol-A-carbonate) (PC) and 0.02 g of bis(ethylenthio)tetrathiafulvalene (BET-TTF) in 50 ml of 1,2-dichlorobenzene at 80°C. The resulting solution is deposited over a glass surface at 130 °C and is left for the solvent to evaporate obtaining a film which thickness is between 15 and 30 micras. The film surface is then exposed to the vapors of a saturated dilution of iodine in methyl chloride causing the formation on the surface of a metallic layer formed by a crystalline lattice made of intertwined nanocrystals of β- (BET-TTF) _{2,5}I₃.

These films have been characterized by X-rays, electronic microscopy techniques and energy dispersive X-ray spectroscopy (EDX). Their conductivity at ambient temperature is of 10 S/cm. The thickness of the conductor layer observed by electron microscopy techniques is of about 1-1.5 micras.

The desired pattern is drawn directly on the conductive surface using a Nd:Yag laser(1064 nm). In this case the irradiated zone also ceases to have conductive properties because the heat caused by the radiation causes the loss of the halogen element. This fact has been again verified by studying the current-voltage responses obtained locally with the point of an atomic force microscope. The relative atomic percentages of sulphur and iodine obtained by EDX analysis are 83% and 17% respectively in the non-irradiated zones, and 93% and 7% respectively, in the irradiated areas.

Also, elements that could be part of electronic circuits such as resistors and condensers as well as a possible design for organic electrodes have been drawn on the film. To this effect the conductor surface was irradiated with a laser beam. The laser beam was aligned to an inverted microscope so the beam was focused on the slide through the viewfinder. The power used on the sample plane was of 0.9mW, creating a power density of approximately 1 kW/cm² using a 5 micras beam diameter. The movement of the slide in relation to the laser beam was monitored with a bidirectional controller, which allowed controlling the speed of movement and its direction. The speed used during this experiment was of 360 µm/s.

## Claims

1. Method for obtaining patterns over an organic conductive substrate comprising the following steps:
expose an organic conductive substrate to a source of heat,
where said organic conductive substrate is a salt or conductive complex comprising a molecule B and a dopant F, where said molecule B is an organic electronic donor or acceptor molecule or macromolecule capable to form a salt or conductive complex, and where said dopant F is an electron acceptor or donor compound capable of forming a salt or conductive complex with the molecule or macromolecule B, in a manner that it causes a thermal reaction that modifies the chemical composition of said organic substrate leaving areas free of dopant F according the following reaction:

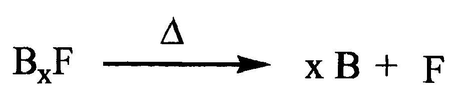

2. Method according to claim 1, **characterized in that** said heat source is applied locally.

3. Method according to claim 2, in which said heat source is selected from amongst laser radiation, a hot point or an electron beam.

4. Method according to claim 1, **characterized in that** said heat source is applied generally throughout the entire surface in the presence of an intermediate mask.

5. Method according to claims 1 and 4 in which said heat source is selected from amongst a luminous or electronic heat source.

6. Method according to claim 4, in which said mask is of polymer nature.

7. Method according to claim 1, **characterized in that** said molecule B is selected from amongst a derivative of acene, coronene, tetrathiafulvalene, tetracyanokinodimethane or a polymer conjugated with polythiofene, polyaniline or polyvinylphenylene.

8. Method according to claim 7, **characterized in that** said tetrathiafulvalene derivative has been selected from amongst bis(ethylenthio) tetrathiafulvalene (BET-TTF), bis(ethylendithio) tetrathiafulvalene (BEDT-TTF) or bis(ethylendioxo) tetrathiafulvalene (BEDO-TTF).

9. Method according to claim 1, **characterized in that** said dopant F is a volatile species.

10. Method according to claim 9, **characterized in that** said volatile species is selected from amongst iodine, bromine or iodine bromide.

11. Method according to claim 1, **characterized in that** said salt is selected between α- (BEDT-TTF) ₂I₃ and β- (BET-TTF) _{2,5}I₃, where BET-TTF is bis(ethylenthio) tetrathiafulvalene , and BEDT-TTF is bis(ethylendithio) tetrathiafulvalene.

12. Organic material that can be obtained according to the method described in any of the previous claims 1 to 11 that comprises a base substrate.

13. Material according to claim 12 **characterized in that** said base substrate is selected from amongst an oxide or inorganic compound, a metal or a flexible polymeric material or a three-dimensional crystal.

14. Material according to claim 13 in which said flexible polymer material is a non-conductive organic polymer.

15. Material according to claim 14 in which said non-conductive organic polymer is selected from amongst polycarbonate, polymethylmethacrylate, polyethylene or polypropylene.

16. Material according to any of claims 12 to 15 **characterized in that** the pattern obtained has a resistance greater than 200 MegaOhms.

17. Use of an organic material that can be obtained according to the method defined in any of the previous claims 1 to 11 to manufacture an electric or an electronic component.

18. Use according to claim 17 in which said electronic component is selected from amongst a resistor, a condenser or a transistor.

19. Use according to claim 17 in which said electric component is selected from amongst an electrode or a sensor.
